(19) Europäisches Patentamt
European Patent Office
Office européen des brevets

(11) EP 3 413 368 A1

(12) **EUROPEAN PATENT APPLICATION**
published in accordance with Art. 153(4) EPC

(43) Date of publication:
**12.12.2018 Bulletin 2018/50**

(21) Application number: **16889388.1**

(22) Date of filing: **24.11.2016**

(51) Int Cl.:
***H01L 51/50*** (2006.01) ***C08G 61/12*** (2006.01)

(86) International application number:
**PCT/JP2016/084757**

(87) International publication number:
**WO 2017/134905 (10.08.2017 Gazette 2017/32)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **04.02.2016 JP 2016019476**

(71) Applicant: **Hitachi Chemical Company, Ltd.**
**Chiyoda-ku**
**Tokyo 100-6606 (JP)**

(72) Inventors:
- **SANO Akihiro**
  **Tokyo 100-8280 (JP)**
- **UEDA Shunsuke**
  **Tokyo 100-6606 (JP)**
- **FUNYUU Shigeaki**
  **Tokyo 100-6606 (JP)**

(74) Representative: **MERH-IP Matias Erny Reichl Hoffmann**
**Patentanwälte PartG mbB**
**Paul-Heyse-Strasse 29**
**80336 München (DE)**

(54) **ORGANIC LIGHT EMISSION ELEMENT**

(57) Used is an organic light emitting device having an anode, a hole transport layer, a emission layer, and a cathode, in which: the hole transport layer is arranged between the anode and the emission layer; the hole transport layer includes an ion polymerization initiator and a curable resin; the curable resin has a hole carrier generated by being doped chemically by the ion polymerization initiator; and the hole transport layer shows ohmic conductivity. The present invention therefore makes it possible to increase the luminous efficiency of an organic light emitting device and improve a service life characteristic.

FIG. 1

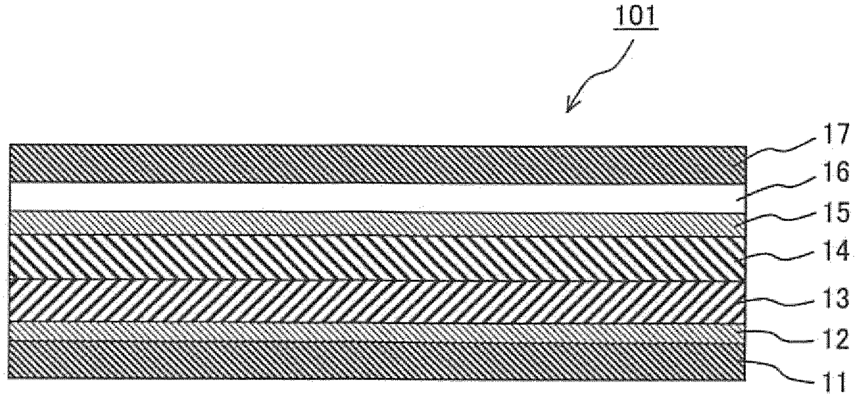


EP 3 413 368 A1

## Description

### Technical Field

The present invention relates to an organic light emitting device.

### Background Art

An organic light emitting device draws attention as a device that can provide a thin, light-weight, and flexible illuminator or display by using organic solid materials with several tens of nanometers in thickness. Further, since an organic light emitting device is self-luminous, thus can have a high viewing angle and a high response speed, and is suitable for a high-speed video display, it is expected as a next generation flat panel display or a sheet display. Furthermore, an organic light emitting device can emit light uniformly from a large area and hence attracts attention also as a next generation illuminator.

In an organic light emitting device, by applying voltage to an organic laminated film interposed between an anode and a cathode, holes are introduced from the anode and electrons are introduced from the cathode into the organic laminated film and light is emitted by recombining the electrons and the holes at a emission layer.

An organic light emitting device includes an anode, a hole transport layer to transport holes from the anode to a emission layer, the emission layer, an electron transport layer to transport electrons from a cathode to the emission layer, and the cathode. In order to efficiently inject electrons and holes into a emission layer, several different films are stacked as hole transport layers and electron transport layers respectively.

Methods to construct the multi-layer of organic solid materials of an organic light emitting device are classified roughly into a vacuum deposition method and a wet processing method. In comparison with a vacuum deposition method, a wet processing method represented by a coating print method or an ink-jet method is expected because of the advantages of mass productivity, cost reduction in a manufacturing process, and a larger screen.

A problem of a wet processing method is that, in the event of coating an organic film, an already stacked layer melts when a next layer is formed. As a measure against the problem, there is a method of: applying a curable solution containing a main agent polymer, which includes a curable crosslinking group, by a wet processing method; and successively curing a polymer by heat or light treatment. The cured film (cured resin) has the nature of being hard to be soluble in a solvent and hence stacking by the wet processing method is facilitated.

There are the following technologies as means for curing organic molecules in a conventional organic light emitting device.

Patent Literature 1 describes that: the solubility of a hole transport layer lowers after reaction by forming a composition for the hole transport layer over a hole injection layer, successively polymerizing a polymerizable compound, and thus forming the hole transport layer; and, by means of this, the hole transport layer 4 does not dissolve when the organic light emitting layer is further formed over the hole transport layer.

Patent Literature 2 describes that, in an organic electroluminescent device: a hole transport layer is formed of a cured resin obtained by subjecting a polymerizable compound containing a ring-opening polymerization group under the existence of a polymerization initiator; and an excellent mass productivity and a high luminous efficiency can be materialized because a maximum peak height Rp and a maximum valley depth Rv at the top surface of the hole transport layer are 14 nm or less respectively.

### Citation List

### Patent Literatures

Patent Literature 1: Japanese Patent Application Laid-Open No. 2008-227483
Patent Literature 2: International Publication No. WO2014/038071

### Summary of Invention

### Problems to be resolved by the Invention

A film thickness formed through a coating process is likely to be ununiform in comparison with a vapor deposition method. In a conventional organic light emitting device, an electric current passing through a hole transport layer depends on a space-charge-limited current mechanism.

A space-charge-limited current is an electric current injected from an anode into a hole transport layer and the injected current forms a space charge in the hole transport layer. It is known that a space-charge-limited current is inversely proportional to the cube of a film thickness. The current distribution in a hole transport layer therefore comes to be ununiform further than the unuiformity of a film thickness and that leads to the deterioration of efficiency. Moreover, that causes a part where electric current concentrates to degrade.

An organic light emitting device in which an organic layer such as a hole transport layer is formed of organic molecules containing a crosslinking group is known as stated above.

An organic layer described in Patent Literature 1 neither provides a uniform film thickness that is a challenge of a coating process nor reduces the ununiformity of a current distribution caused by the ununiformity of a film thickness.

In the method described in Patent Literature 2, although a maximum peak height Rp and a maximum valley depth Rv of a hole transport layer are 14 nm or less respectively, the film thickness of a hole transport layer is several tens of nanometers, hence uniformity is large, and electric current is ununiform.

An object of the present invention is to increase the luminous efficiency of an organic light emitting device and prolong life time of device.

### Means of Solving the Problems

In order to solve the above problem, used is an organic light emitting device having an anode, a hole transport layer, emission layer, and a cathode, wherein: the hole transport layer is arranged between the anode and the emission layer; the hole transport layer includes an ion polymerization initiator and a curable resin; the curable resin has a hole carrier generated by being doped chemically by the ion polymerization initiator; and the hole transport layer shows an ohmic conductivity.

### Advantageous Effects of the Invention

The present invention makes it possible to increase the luminous efficiency of an organic light emitting device and prolong life time of device.

### Brief Description of Drawings

Fig. 1 is a schematic sectional view showing a structure of an organic light emitting device.
Fig. 2 is a schematic view comparatively showing current density distributions of space-charge-limited current and current density distributions of ohmic current.
Fig. 3 is a graph showing a relationship between $E_n$ and $X_n$.
Fig. 4 is a graph showing a relationship between a characteristic length D and a hole density.
Fig. 5A is a graph showing a relationship between a current density and a voltage in a hole transport layer.
Fig. 5B is a graph showing a relationship between a hole density $n_0$ and a voltage.
Fig. 6A is a graph showing a relationship between a voltage applied to a hole transport layer and a current density when the mixing ratio of an ion initiator is used as a parameter.
Fig. 6B is a graph showing the results of calculated differential values of current densities in Fig. 6A on the voltage.
Fig. 7 is a schematic configuration.diagram showing a hole-only device and an impedance measurement system.
Fig. 8 is a schematic configuration diagram showing an organic light emitting device and an impedance measurement system.

### Description of Embodiments

The present invention relates to an organic light emitting device: using a cured resin with which an ion initiator is mixed; and having a hole transport layer of ohmic conductivity.

Embodiments according to the present invention are explained hereunder.

<Organic light emitting device using cured resin containing ion initiator as hole transport layer>

In the present description, a "curable polymer" means a resin cured (hereunder referred to also as a "cured resin") by, after a substrate is coated with the resin, initiating crosslinking reaction of macromolecules having crosslinking groups binding to side chains and forming crosslinks between and/or in the macromolecules through a curing process of heat or light. In the following examples, the explanations are made on the basis of a curable polymer formed by

crosslinking macromolecules with crosslinking groups but a configuration of crosslinking a low-molecular organic material with a crosslinking group is also acceptable.

In the production of an organic light emitting device, when a next organic layer is stacked over an underlying organic layer through a wet process, the underlying organic layer dissolves undesirably. In contrast, a layer formed by applying a curable polymer through a wet process and successively curing the curable polymer through a curing process of heat or light does not dissolve and survives even when a next layer is applied through a wet process.

Further, a cationically polymerizable ion polymerization initiator is composed of a combination of positively charged cationic molecules and negatively charged counter anionic molecules (hereunder referred to as an "ion polymerization initiator" including ions remaining in a cured resin after the cure in the above ions). A cationic molecule is a chemical compound that is activated through a curing process and accelerates the crosslinking reaction of a crosslinking group. An anionic molecule is a molecule that is added in order to keep the neutralization of the positive charge of a cationic molecule and is stable in a negatively charged state.

A charge-transporting or luminous monomer included in a main chain in a macromolecular composition of a curable polymer according to the present invention may be any monomer as long as the monomer is a known monomer used for producing an organic element, for example for producing a resin forming a hole transport layer, emission layer, or an electron transport layer of an organic light emitting device. As such monomers, although they are not definitive, named are for example aryl amine, stilbene, hydrazone, carbazole, aniline, oxazole, oxadiazole, benzoxazole, benzoxadiazole, benzoquinone, quinoline, isoquinoline, quinoxaline, thiophene, benzothiophene, thiadiazole, benzodiazole, benzothiadiazole, triazole, perylene, quinacridone, pyrazoline, anthracene, rubrene, coumarin, naphthalene, benzene, biphenyl, terphenyl, anthracene, tetracene, fluorene, phenanthrene, pyrene, chrysene, pyridine, pyrazine, acridine, phenanthroline, furan, pyrrole, and a chemical compound having a derivative of any one of those as a skeleton.

Preferably, a linear or branched conjugated monomer is selected from the chemical compounds each of which has a molecular framework represented by any one of the following structural expressions (1) to (3).

[Ch 1]

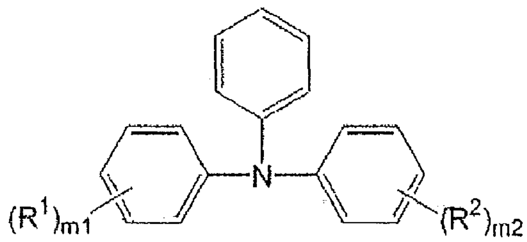

(1)

[Ch 2]

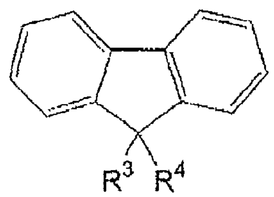

(2)

[Ch 3]

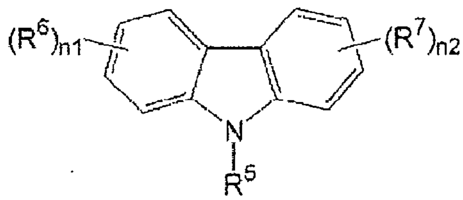

(3)

In those structural expressions, $R^1$ to $R^7$ are, independently from each other, selected from: preferably the group of hydrogen, halogen, a cyano group, a nitro group, a linear, branched, or cyclic alkyl group of 1-22C, a linear, branched, or cyclic alkenyl group of 2-22C, a linear, branched, or cyclic alkynyl group of 2-22C, an aryl group of 6-21C, a heteroaryl group of 12-20C, an aralkyl group of 7-21C, and a heteroarylalkyl group of 13-20C; yet preferably the group of hydrogen, halogen, a cyano group, a nitro group, a linear, branched, or cyclic alkyl group of 1-22C, an aryl group of 6-21C, a heteroaryl group of 12-20C, and an aralkyl group of 7-21C; still yet preferably the group of hydrogen, halogen, a linear, branched, or cyclic alkyl group of 1-10C, and an aryl group of 6-10C; or particularly preferably the group of hydrogen, bromine, a methyl group, an ethyl group, a propyl group, a butyl group, a pentyl group, a hexyl group, a heptyl group, an octyl group, a nonyl group, a decyl group, and a phenyl group.

Each of the above functional groups is: preferably not replaced or replaced with one or more halogens; or yet preferably not replaced.

Each of m1 and m2, independently from each other, is: preferably any integer between 0 and 5; or yet preferably 0 or 1.

Each of n1 and n2, independently from each other, is: preferably any integer between 0 and 4; or yet preferably 0 or 1.

In the present description, an "aralkyl group" means a functional group formed by replacing one hydrogen atom in an alkyl group with an aryl group. As preferable aralkyl groups, although they are not definitive, for example a benzyl group, a 1-phenethyl group, and a 2-phenethyl group can be named.

In the present description, an "arylalkenyl group" means a group formed by replacing one hydrogen atom in an alkenyl group with the aryl group. As a preferable arylalkenyl group, although it is not definitive, for example a styryl group can be named.

In the present description, a "heteroaryl group" means a group formed by replacing at least one carbon atom in an aryl group with a heteroatom selected from a nitrogen atom (N), a sulfur atom (S), and an oxygen atom (O) respectively independently. For example, a "heteroaryl group of 12-20C" or a "heteroaryl group of 12-20 (ring) members" means a group formed by replacing at least one carbon atom in an aromatic group containing at least 12 or at most 20 carbon atoms with the above heteroatoms respectively independently.

On this occasion, the replacement with N or S includes the replacement with an N-oxide, an S-oxide, or a dioxide, respectively. As preferable heteroaryl groups, although they are not definitive, named are for example a furanyl group, a thienyl group, a pyrrolyl group, an imidazolyl group, a pyrazolyl group, a triazolyl group, a tetrazolyl group, a thiazolyl group, an oxazolyl group, an isoxazolyl group, an oxadiazolyl group, a thiadiazolyl group, an isothiazolyl group, a pyridyl group, a pyridazinyl group, a pyrazinyl group, a pyrimidinyl group, a quinolinyl group, an isoquinolinyl group, and an indolyl group.

In the present description, a "heteroarylalkyl group" means a group formed by replacing one hydrogen atom in an alkyl with the heteroaryl group.

In the present description, a "halogen" means fluorine, chlorine, bromine, or iodine.

Particularly preferably, a charge-transporting or luminous monomer is selected from triphenylamine, N-(4-butylphenyl)-N',N"-diphenylamine, 9,9-dioctyl-9H-fluorene, N-phenyl-9H-carbazole, N,N'-diphenyl-N,N'-bis(3-methylphenyl)-[1,1'-biphenyl]-4,4'-diamine, N,N'-bis(3-methylphenyl)-N,N'-bis(2-naphthyl)-[1,1'-biphenyl]-4,4'-diamine, and a chemical compound having a derivative of any one of those as a molecular framework.

As a hole transport layer, by using a macromolecular composition having a main chain of a charge-transporting or luminous monomer having such a molecular framework as stated above, the ionization energy of the hole transport layer can be adjusted to an appropriate value in response to the ionization energy of a light emitting layer material. Usually, a value between the work function of an anode and the ionization energy of an emission layer or a value larger than the ionization energy of the emission layer is preferable.

An organic light emitting device according to the present invention includes at least one hole transport layer between an anode and a light emitting layer and at least one electron transport layer between the emission layer and a cathode, respectively. An electron blocking layer may be arranged in order to prevent electrons from passing through

from a light emitting layer but a layer arranged between an anode and a emission layer such as an electron blocking layer is called a "hole transport layer" in the present description. Likewise, an electron transport layer includes a hole blocking layer.

Further, a curing process stated above is applied to a mixture obtained by mixing a crosslinking polymer and an ion polymerization initiator. In the present invention, a hole carrier is doped chemically in a curable resin of a hole transport layer by an ion polymerization initiator. Here, the ion polymerization initiator is activated by the curing process and has the function of accelerating the crosslinking reaction of a crosslinking group.

As crosslinking initiators applied to a curing process of a curable polymer according to the present invention, for example an iodonium salt, a sulfonium salt, and a ferrocene derivative can be named. The crosslinking initiators are preferable because of a high reactivity.

An ion polymerization initiator is selected particularly preferably from the chemical compounds represented by the following structural expressions (4) to (6).

[Ch 4]

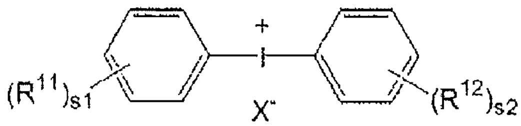

(4)

[Ch 5]

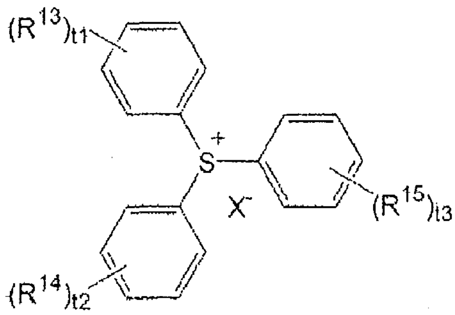

(5)

[Ch 6]

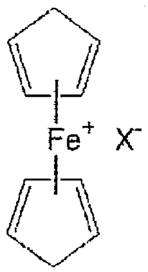

(6)

In those structural expressions, $X^-$ is $Sb_6^-$, $(C_6F_5)_4B^-$, $CF_3SO_3^-$, $PF_6^-$, $BF_4^-$, $C_4F_9SO_3^-$, or $CH_3C_6H_4SO_3^-$ and $R^{11}$ to $R^{15}$ are, independently from each other, selected from: preferably the group of hydrogen, halogen, a cyano group, a nitro group, a linear, branched, or cyclic alkyl group of 1-22C, a linear, branched, or cyclic alkenyl group of 2-22C, a linear, branched, or cyclic alkynyl group of 2-22C, an aryl group of 6-21C, a heteroaryl group of 12-20C, an aralkyl group of 7-21C, and a heteroarylalkyl group of 13-20C; yet preferably the group of hydrogen, halogen, a cyano group, a nitro group, a linear, branched, or cyclic alkyl group of 1-22C, an aryl group of 6-21C, a heteroaryl group of 12-20C, and an

aralkyl group of 7-21C; and still yet preferably hydrogen.

Each of s1, s2, t1, t2, and t3, independently from each other, is preferably any integer between 0 and 5.

Particularly preferably, crosslinks are formed between and/or in molecules by applying heat treatment to a mixture obtained by mixing a curable polymer according to the present invention and a crosslinking initiator explained above and reacting a crosslinking group. On this occasion, a temperature of the heat treatment is preferably in the range of 100°C to 250°C.

Further, the time of the heat treatment is preferably in the range of 10 to 180 minutes.

In the present invention, the conduction characteristic of a curable resin of a hole transport layer is ohmically conductive by a hole carrier doped chemically by an ion polymerization initiator.

Fig. 2 is a schematic view showing comparison between the current density distributions of space-charge-limited current and the current density distributions of ohmic current.

The figure schematically shows cross sections of an organic light emitting device and represents microscopic distributions of a hole carrier 27 and an electron carrier 28.

In the case of assuming a space-charge-limited current, an organic light emitting device has a structure formed by stacking a glass substrate 21, an anode 22, a hole transport layer 23a (curable resin of space-charge-limited conductivity), a hole transport layer 23b (curable resin of space-charge-limited conductivity), a emission layer 24, an electron transport layer 25, and a cathode 26 in this order. In the state of not applying voltage, a hole carrier 27 distributes in the hole transport layer 23a and the hole transport layer 23b without bias. In contrast, in the state of applying voltage, an electron carrier 28 is generated in the cathode 26 and moves toward the hole transport layer 23b. On this occasion, the hole carrier 27 comes to be ununiform and regions of high densities and regions of low densities are generated.

On the other hand, in the case of assuming an ohmic current, an organic light emitting device has a structure formed by stacking a glass substrate 21, an anode 22, a hole transport layer 23c (curable resin of ohmic conductivity), a hole transport layer 23d (curable resin of ohmic conductivity), a emission layer 24, an electron transport layer 25, and a cathode 26 in this order. In the state of not applying voltage, a hole carrier 27 distributes in the hole transport layer 23c and the hole transport layer 23d without bias more densely than the case of the space-charge-limited current. Then in the state of applying voltage, an electron carrier 28 is similar to the case of the space-charge-limited current but the hole carrier 27 keeps the state of distributing uniformly and the current density is also uniform.

The reason of making such difference is as follows.

When a hole transport layer is formed through a coating process, the film thickness is likely to be ununiform. Further, when an ITO that is an anode is patterned, the film thickness reduces at a step between the ITO and a glass substrate.

If an ununiform film thickness exists, a current density of a space-charge-limited current is inversely proportional to the cube of a film thickness and hence electric current concentrates at a thin film part. In contrast, a current density of an ohmic current is inversely proportional to the first power of a film thickness and hence the ununiformity of electric current is alleviated in comparison with a space-charge-limited current.

When ununiformity in a current density distribution is alleviated in this way, a luminous efficiency improves. Further, by alleviating electric current concentration at a thin film, degradation at a thin film part is inhibited and the drive life improves.

<Adjustment of coating liquid>

An ion polymerization initiator contained in a curable resin used as a hole transport layer in an organic light emitting device according to the present invention not only advances crosslinking reaction but also materializes ohmic conductivity by chemically doping a hole carrier. It sometimes happens that a larger addition amount of an ion polymerization initiator than usual is required to be dissolved in a coating liquid.

As a dissolving method, there is a method of dissolving a curable polymer and an ion polymerization initiator in different solvents and then mixing them. The concentrations of the curable polymer and the ion initiator in respective solvents before the mixing are adjusted so that the proportions of the curable polymer and the ion polymerization initiator after the mixing may take prescribed values. Otherwise, there is a method of selecting an initiator having a molecular structure having a high affinity with a solvent as an ion polymerization initiator.

<Space-charge-limited current>

A unit system in mathematical models shown below is an SI unit and [$A/m^2$] is used as the unit of a current density, [$m^2/V/sec$] is used as the unit of a mobility, [$/m^3$] is used as the unit of a density, and [m] is used as the unit of a film thickness. In the numerical values shown concretely below as experimental conditions, [$mA/cm^2$] is used as the unit of a current density, [$cm^2/V/sec$] is used as the unit of a mobility, [$/cm^3$] is used as the unit of a density, and [nm] is used as the unit of a film thickness in accordance with the custom but the values are converted into the SI unit when

evaluation is carried out on the basis of the mathematical models.

A conventional organic solid used for a hole transport layer in an organic light emitting device shows a good insulation characteristic when a film thickness is not thinner than several $\mu$m. That is, a hole freely conductive in an organic solid does not exist in the state of not applying voltage. When a voltage is applied to an organic solid in the form of a thin film of 100 nm or less, holes are injected from an anode and the current of holes conducts. The injected holes form a space charge in the organic solid. The space charge generates an electric field in the interior of a resin. A conduction mechanism by electrons and holes that are injected into the resin and form a space charge is called a "space-charge-limited current".

The relationship between an electric current and a voltage based on a space-charge-limited current is explained hereunder.

A direction of an electric current is represented by an x-axis, x = 0 is defined as an interface between an anode and a hole transport layer, x = d is defined as a film thickness of the hole transport layer, and the film thickness is regarded as uniform. When a density of holes being injected from the anode and forming a space charge is defined as $n_{inj}(x)$, a steady-state current j flowing in the hole transport layer is given by the following expression (1).

[Num 1]

$$j = e \cdot n_{inj}(x) \cdot \mu \cdot E(x) \qquad (1)$$

Here, e is an elementary electric charge (= $1.6 \times 10^{-19}$ [C]), $\mu$ is a mobility of holes, and E(x) is an electric field.

The relationship between a space charge $n_{inj}$ and an electric field E in a resin is given by the Poisson's equation represented by the following expression (2).

[Num 2]

$$\frac{dE}{dx} = \frac{e \cdot n_{inj}(x)}{\varepsilon \varepsilon_0} \qquad (2)$$

Here, $\varepsilon$ is a relative dielectric constant.and $\varepsilon_0$ is a dielectric constant of a vacuum (= $8.85 \times 10^{-12}$ [F/m]).

By substituting the expression (2) for the expression (1), a space-charge-limited current expression represented by the following expression (3) is obtained.

[Num 3]

$$j = \mu \cdot \varepsilon \cdot \varepsilon_0 \cdot \frac{dE}{dx} \cdot E(x) \qquad (3)$$

In a steady state, j is constant regardless of a coordinate. By integrating the electric field E in the range of x = 0 to x = film thickness d, the following expression (4) is obtained.

[Num 4]

$$j = \frac{9\mu \cdot \varepsilon \cdot \varepsilon_0}{8d^3} \cdot V^2 \qquad (4)$$

As a boundary condition, E is set at 0 at x = 0. An electric current is proportional to the square of a voltage applied to a hole transport layer and inversely proportional to the cube of a film thickness d. When a film thickness is ununiform therefore, the ununiformity of a current density increases. An electric current increases particularly at a thin film part.

<Ohmic current>

As shown in the upper right section of Fig. 2, in the case of an organic light emitting device having a hole transport layer formed of a curable resin according to the present invention, the curable resin contains an ion polymerization initiator and, even in the state of not applying voltage, a hole carrier is pre-doped in the curable resin.

When a density of pre-doped holes is represented by no, a current density is given by the following expression (5).

[Num 5]

$$j = e \cdot n_0 \cdot \mu \cdot E(x) \tag{5}$$

An electric current is proportional to a voltage applied to a hole transport layer and inversely proportional to the first power of a film thickness d. The ununiformity of a current density relative to the ununiformity of a film thickness therefore is alleviated in comparison with electric conduction based on a space-charge-limited current mechanism.

<Ohmic current condition>

The present inventors have found that an electrical conduction mechanism does not generate ohmic current even with a curable resin formed by adding an ion initiator and doping holes beforehand. Further, the present inventors have devised an evaluation model for determining whether an electrical conduction mechanism in a hole transport layer generates space-charge-limited current or ohmic current.

The evaluation model is shown hereunder.

An expression obtained by combining terms of the space-charge-limited current expression (3) and the ohmic current expression (5) is used for calculating a current density j. As a result, an expression reflecting both the phenomena is obtained.

[Num 6]

$$j = \mu \cdot \varepsilon \cdot \varepsilon_0 \cdot \frac{dE}{dx} \cdot E(x) + e \cdot n_0 \cdot \mu \cdot E(x) \tag{6}$$

In the expression (5), an electric field E does not depend on a coordinate. In contrast, the expression derived from ohmic current in the second term on the right side of the expression (6) takes the coordinate dependence caused by the existence of a space charge into consideration. The following expression (7) is obtained by integrating both the sides with respect to x.

[Num 7]

$$-E_n - \log(1 - E_n) = x_n \tag{7}$$

Here, $E_n$ is a normalized dimensionless electric field proportional to an electric field E and $x_n$ is a normalized dimensionless coordinate. They are expressed by the following expressions (8) and (9).

[Num 8]

$$E_n = \frac{E(x)}{j/(e \cdot \mu \cdot n_0)} \tag{8}$$

[Num 9]

$$x_n = \frac{x}{\left(\dfrac{j \varepsilon \varepsilon_0 \mu}{(e \cdot \mu \cdot n_0)^2}\right)} \tag{9}$$

Fig. 3 is a graph obtained by plotting a relationship between $E_n$ and $x_n$. A normalized coordinate $x_n$ is shown on the horizontal axis and a normalized electric field $E_n$ is shown on the vertical axis.

As shown in the figure, when $x_n$ is sufficiently larger than 1, $E_n$ takes a value of 1. In the region where $E_n$ is

close to 1, the ohmic current is the main component. In contrast, when xn is sufficiently smaller than 1, the electric current is a space-charge-limited current. Whether the electric current is a space-charge-limited current or an ohmic current is determined therefore in accordance with a relationship between a characteristic length D given at a denominator of $x_n$ and a film thickness. A characteristic length D is defined by the following expression (10).

[Num 10]

$$D = \frac{j\varepsilon\varepsilon_0\mu}{(e\cdot\mu\cdot n_0)^2} \quad (10)$$

A relationship between a characteristic length D and a hole density is explained by taking the case of a hole transport layer having a typical characteristic of a hole mobility = $10^{-5}$ [$cm^2$/V/sec] and a relative dielectric constant = 3.2 as the example.

Fig. 4 is a graph showing a relationship between D and a hole density no when an operating current density j of an organic light emitting device is 100 mA/$cm^2$. Here, since the organic light emitting device has a configuration of connecting an anode, a hole transport layer, a light emitting layer, and a cathode in series, an operating current density of the organic light emitting device is identical to the current density of the hole transport layer in a steady state.

When a hole density $n_0$ is less than $10^{18}$ [/$cm^3$], D is more than 20 nm and is the same level as the film thickness of each organic layer used in an ordinary organic light emitting device. The electric current therefore is not ohmic current. In contrast, when $n_0$ is more than $10^{19}$ [/$cm^3$], D is less than 1 Å. 1 Å corresponds to one atomic layer, the whole film is in an ohmic region, and an electric current derived from space-charge current limit is ohmic current.

With regard to the expression (7), a current density j and a voltage applied to a hole transport layer are calculated by integrating an electric field E in the range of x = 0 to x = film thickness d. j is set in the range of 0 to 1,000 mA/$cm^2$, a mobility and a relative dielectric constant are set at the conditions identical to Fig. 4, and a film thickness is set at 40 nm.

The results are shown in Fig. 5A. Space-charge-limited current densities are also plotted on the basis- of the expression (4).

As shown in the figure, in the range where a hole density $n_0$ is less than $10^{18}$ [/$cm^3$], an electric current is proportional to the square of a voltage and is a space-charge-limited current. In contrast, when a hole density no is more than $10^{18}$ [/$cm^3$], an electric current is proportional to the first power of a voltage and is linear. That is, an electric current is ohmic current.

In Fig. 5B, hole densities no on the horizontal axis and voltages at a current density of 500 mA/$cm^2$ on the vertical axis are plotted. The calculation conditions are the same as Fig. 5A and, with regard to the expression (7), a current density j and a voltage applied to a hole transport layer are calculated by integrating an electric field E in the range of x = 0 to x = film thickness d.

Further, in the case of ohmic conduction, in the expression (5), an electric field E does not depend on a coordinate x and is given by the expression E = V/d (V is an applied voltage and d is a film thickness). The relationship between a voltage V and a hole density no in the case of an ohmic current therefore is given by the following expression (11).

[Num 11]

$$V = \frac{j\cdot d}{e\cdot\mu\cdot n_0} \quad (11)$$

In Fig. 5B, the relationship between a hole density and a voltage at a current density of 500 mA/$cm^2$ given by the expression (11) is also plotted. When a hole density no is more than $10^{18}$ [/$cm^3$], the curve calculated from the expression (7) and the curve calculated from the expression (10) coincide with each other. In contrast, when a hole density $n_0$ is less than $10^{18}$ [/$cm^3$], they do not coincide with each other and a voltage is constant regardless of the value no. This is because the electric current is a space-charge-limited current caused by holes injected from an electrode when the hole density no is less than $10^{18}$ [/$cm^3$]. It is understood therefore that ohmic conductivity is shown when a hole density no is more than $10^{18}$ [/$cm^3$].

Such a hole transport layer as to generate ohmic current is a layer containing an ion polymerization initiator and a curable resin of ohmic conductivity. A "curable resin of ohmic conductivity" generates a so-called ohmic current because the density of a hole carrier doped chemically by an ion polymerization initiator is high.

In summary, in an organic light emitting device, a curable resin constituting a hole transport layer has a hole carrier generated by being doped chemically by an ion polymerization initiator and the hole transport layer shows ohmic conductivity.

As a range of D that gives an ohmic current, it is preferable that 90% or more of a film thickness d falls in an ohmic current region. In Fig. 3, a normalized coordinate where a normalized electric field exceeds 0.9 is 2.0. In the region where a normalized coordinate is 2.0 or less, ohmic conductivity does not exist. Under the condition that a whole film thickness is a film thickness corresponding to the normalized coordinate 2.0 × 10 = 20 or more (defined as a "normalized film thickness"), a region where ohmic conductivity does not exist is 10% or less and 90% or more of the whole film thickness is an ohmic current region. It is obvious therefore that ohmic current is obtained when the expression "normalized film thickness = film thickness d/characteristic length D > 20" is satisfied, namely when a characteristic length D is less than 1/20 of a film thickness. In the state, the following expression (12) is satisfied.
[Num 12]

$$\frac{j\varepsilon\varepsilon_0}{\mu(en_0)^2} < \frac{d}{20} \qquad (12)$$

According to the expression (12), when a film thickness d is thin, the upper limit of the inequality necessary for obtaining ohmic current reduces. When the film thickness of a hole transport layer is ununiform, the minimum value of the film thickness of the hole transport layer, namely the hole transport layer, desirably satisfies the inequality (12) in a region of 90% or more of the area of an interface in contact with an anode or a emission layer.
As explained in Fig. 4, when $n_0$ is more than $10^{19}$ [/cm$^3$], D is less than 1 Å and the whole film falls in an ohmic region. The following expression (13) is obtained by generalizing the desirable state.
[Num 13]

$$\frac{j\varepsilon\varepsilon_0}{\mu(en_0)^2} < 1\text{Å} \qquad (13)$$

<Upper limit of hole density>

In an organic light emitting device, it is not desirable for a hole transport layer to reflect light coming from an emission layer when the light is extracted from an anode. In general, a metal such as copper or aluminum reflects light having a smaller energy than a plasma frequency $\omega_p$ given by the following expression (14) in response to the density n of electrons in the metal and exhibits luster intrinsic to the metal.
[Num 14]

$${\omega_p}^2 = \frac{ne^2}{\varepsilon\varepsilon_0 m} \qquad (14)$$

Here, $\varepsilon$ is a relative dielectric constant of a material, $\varepsilon_0$ is a dielectric constant of a vacuum, and m is an effective mass of electrons or holes. A electron density of copper or aluminum is $10^{22}$ or more [/cm$^3$]. A desirable hole density is $10^{22}$ or less [/cm$^3$] in order to prevent a hole transport layer from reflecting light.

<Measurement principle of hole density $n_0$>

An element of a structure formed by interposing a hole transport layer between electrodes such as an anode ITO and a cathode Al is called a "hole-only element". A region of a low hole density (called a "depletion layer") is generated on the hole transport layer side at an interface between a hole transport layer and Al because of the difference between the work function (5 eV or more) of the hole transport layer and the work function (4.2 eV) of Al. The thickness d' of a depletion layer is given by the following expression (15).
[Num 15]

$$d' = \left\{ \frac{2\varepsilon\varepsilon_0 (\Delta\phi - V)}{e n_0} \right\}^{\frac{1}{2}} \qquad (15)$$

Here, $\Delta\phi$ is a difference in work function between a hole transport layer and Al and V is a voltage applied between an anode and a cathode.

A capacitance C' in a depletion layer is given by the following expression (16).

[Num 16]

$$C' = \frac{\varepsilon \cdot \varepsilon_0 \cdot S}{d'} \qquad (16)$$

Here, S is an area of a device. A hole density no is obtained by applying a voltage between an anode and a cathode and measuring a capacitance.

A capacitance derived from a depletion layer can be separated by measuring the frequency dependence of an impedance in a hole-only device using an LCR meter.

<Organic light emitting device>

Fig. 1 is a schematic sectional view showing an organic light emitting device according to an embodiment of the present invention.

In the figure, an organic light emitting device 101: has a glass substrate 11, an anode 12, a hole transport layer 13 (also referred to as a "hole injection layer" in some cases), a emission layer 14, an electron transport layer 15, a cathode 16, and a sealing glass plate 17; and has a configuration formed by stacking them in this order.

The anode 12 is formed for example by patterning an indium tin oxide (ITO) over the glass substrate 11. A substrate obtained by patterning an ITO as an anode 12 over a glass substrate 11 is called an "ITO glass substrate" hereunder.

The cathode 16 is formed for example by: forming the hole transport layer 13 and the emission layer 14 in sequence over the glass substrate 11 with the anode 12 that is the ITO glass substrate; and successively forming aluminum (Al) by vapor deposition over the emission layer 14. Further, it is desirable to: stack the sealing glass plate 17 over the cathode 16; and seal them by bonding the glass substrate 11 and the sealing glass plate 17 with a curable resin such as a photocurable epoxy resin for example.

In an organic light emitting device according to the present invention, a hole transport layer is produced by using a resin formed by a crosslinkable polymer. The hole transport layer can be produced by using a means used commonly in the technical field of the art. For example, the hole transport layer may be produced by: applying a curable polymer according to the present invention over an anode patterned over a glass substrate by a wet process such as a spin coating method, a printing method, or an ink-jet method; and successively forming a resin through a curing process explained above.

A resin formed by a polymerizable coating liquid has a high curability and is excellent in organic solvent resistance. When an emission layer is stacked over the surface of a hole transport layer produced by using the resin for example through a wet process therefore, it is possible to inhibit the hole transport layer from dissolving in an organic solvent contained in a coating liquid of the emission layer. In a hole transport layer produced by using a resin formed by a curable polymer according to the present invention for example, a remaining film ratio is usually in the range of 60% to 100% or typically in the range of 80% to 99%. A resin having an organic solvent resistance represented by the above remaining film ratio is highly curable. It is therefore possible to improve the productivity of an organic light emitting device through a wet process by using a resin according to the present invention for a hole transport layer.

Here, a remaining film ratio can be evaluated through the following procedure for example. A hole transport layer is produced over an anode of an ITO glass substrate by using a resin formed by a curable polymer and an ion polymerization initiator according to the present invention. The ITO glass substrate over which the hole transport layer is formed is immersed in an organic solvent (for example toluene) for 10 to 60 seconds at 20°C to 250°C. Successively, the ITO glass substrate is taken out from the organic solvent and the absorbances of a thin film before and after the immersion are measured. The proportion of the remaining thin film (remaining film ratio) is obtained from the ratio of the absorbances. An absorbance is proportional to a film thickness and hence a ratio of absorbances (with immersion/without immersion) coincides with a remaining film ratio (with immersion/without immersion) of a hole transport layer. An organic

solvent resistance is evaluated to be higher as a remaining film ratio increases.

The present invention is explained more concretely in reference to examples hereunder. The technological scope of the present invention however is not limited to the examples.

## Example 1

A curable resin used for a hole transport layer of ohmic conductivity is explained.

[Synthesis of crosslinkable polymer]

A crosslinkable polymer is synthesized by polymerizing a linear triphenylamine monomer (1), a branched triphenylamine monomer (2), and an oxetane crosslinking monomer (3) through Suzuki reaction. The crosslinkable linear triphenylamine monomer (1) and branched triphenylamine monomer (2): have two and three reaction points of the Suzuki reaction respectively; and form main chains by polymerization.

The crosslinkable oxetane crosslinking monomer (3): has a reaction point of the Suzuki reaction; and forms a side chain by polymerization. The crosslinkable oxetane crosslinking monomer (3) is a monomer having a structure formed by connecting a 1-ethyloxetane-1-yl group with a divalent crosslinking group formed of the combination of phenylene and oxymethylene.

[Ch 7]

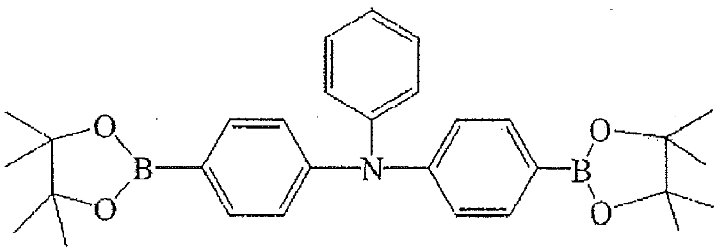

(7)

[Ch 8]

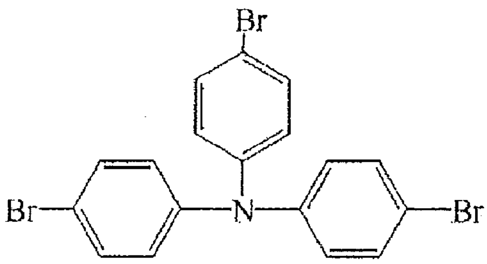

(8)

[Ch 9]

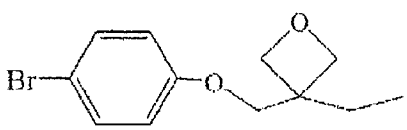

(9)

4,4'-bis(4,4,5,5-tetramethyl-1,3,2-dioxaborolane-2-yl)-4"-n-butyltriphenylamine (1) (0.4 mmol), 4,4',4"-tribromotriphenylamine (2) (1.0 mmol), 3-(4-bromophenoxymethyl)3-ethyloxetane (3) (1.2 mmol), 2-bromo-3-n-octylthiophene (4) (5.3 mmol), tetrakistriphenylphosphine palladium (0.008 mmol), 2M potassium carbonate aqueous solution (5.3 mmol), Aliquat (registered trademark) 336 (0.4 mmol), and anisole (4 ml) were put into a round-bottom flask and stirred

for 2 hours at 90°C under a nitrogen atmosphere.

A macromolecular composition A having a crosslinking group of 40 kDa in molecular weight was obtained by synthesizing a crosslinkable linear triphenylamine monomer (1), a crosslinkable branched triphenylamine monomer (2), and a crosslinkable oxetane crosslinking monomer (3) at a molar ratio of 20:50:40 by the above method. The molecular weight was determined by number average measured in terms of polystyrene through gel permeation chromatography.

[Preparation of coating liquid]

The aforementioned curable polymer (oligomer) of 4.2 mg and an ion initiator represented by the aforementioned structural expression (4) (in the expression, cations $R^{11}$ and $R^{12}$ are H respectively, s1 and s2 are 1 respectively, and an anion X is $(C_6F_5)_4B$) of any one of the contents of 0.02, 0.04, and 0.42 mg (corresponding to z = 0.5, 1.0, and 10 mass parts respectively to the curable polymer of 100 mass parts) are dissolved in toluene of 1.2 ml.

In the case where the content of the ion initiator was 0.42 mg, since the concentration of the ion initiator was high, the solution became muddy. When the curable polymer of 4.2 mg was dissolved in toluene of 0.6 ml and the ion polymerization initiator of 0.42 mg was dissolved in toluene of 0.6 ml separately and then the solutions were mixed, the muddiness disappeared.

[Formation of resin using crosslinkable polymer]

Indium tin oxide (ITO) was patterned in a width of 1.6 mm over a glass substrate. The ITO glass substrate was coated with the above coating liquid by spin coating under the condition of 300 rpm. Successively, a resin was formed by: curing the ITO glass substrate coated with a crosslinkable polymer by heating for 7 minutes at 180°C on a hot plate; and thus heating and polymerizing the curable polymer. The resin is defined as a resin A(z) (z = 0.5, 1.0, or 10 mass parts).

[Evaluation of remaining film ratio]

A thin film of the resin A(z) (z = 0.5, 1.0, or 10 mass parts) together with the glass plate was rinsed in toluene, the absorbances of the thin film before and after the rinse were measured, and the ratio of a remaining thin film (remaining film ratio) was obtained from the ratio of the absorbances before and after the rinse. The remaining film ratios of resins A' and A" were 90% or more.

[Evaluation of hole-only device]

An Al electrode 100 nm in film thickness was formed over a sample of the resin A(z) (z = 0.5, 1.0, or 10 mass parts) by vapor deposition. The element is called a "hole-only device". In the present example, after a resin was formed by a method explained in [Formation of resin using crosslinkable polymer], an Al layer 100 nm in film thickness and 1.6 mm in width was patterned. A plane where an ITO pattern and an Al pattern intersect comes to be a light emitting element and the area of the element is given by $1.6 \times 1.6\ mm^2$.

Fig. 6A is a graph showing a relationship between a voltage and a current density of each of the samples. Fig. 6B is a graph showing the values calculated by differentiating the current densities with respect to the voltages in Fig. 6A. The average film thickness was 40 nm in any of the samples. Capacitances were measured and a relative dielectric constant of 3.2 was obtained.

From the figures, space-charge-limited current is obtained in the samples of z = 0.5 and 1.0 mass parts. In contrast, it is obvious that ohmic current is obtained in the sample of z = 10 mass parts.

The differential value of the current density increased in proportion to voltage in each of the samples of z = 0.5 and 1.0 mass parts. When the inclination of the differential value of a current density was assumed to be linear, a hole mobility of $10^{-5}$ [$cm^2$/Vsec] was obtained by using the space-charge-limited current expression (4).

In contrast, in the sample of Z = 10 mass parts, large differential values are obtained from the state where the applied voltage is zero. This shows that ohmic conduction is obtained in the sample of z = 10 mass parts.

Consequently, a mass ratio of a curable resin and an ion polymerization initiator is desirably 100:10 or more.

[Measurement of hole density no]

Fig. 7 is a schematic configuration diagram showing a hole-only device and an impedance measurement system.

In the figure, a hole-only element 501 has a glass substrate 11, an anode 12, a hole transport layer 13, and a cathode 16 and has a configuration formed by stacking them in this order. An LCR meter 502 is connected to the anode 12 and the cathode 16 of the hole-only element 501. An NF circuit block ZM2376 is used as the LCR meter 502.

In such a configuration, the capacitance of the hole-only device 501 was measured. When an applied voltage

was zero, in the range of 0.1 to 100 Hz, capacitance components of $4 \times 10^{-9}$ [F] in the resin of 0.5 mass parts, $1 \times 10^{-9}$ [F] in the resin of 1.0 mass part, and $3 \times 10^{-10}$ [F] in the resin of 1.0 mass part were measured. When voltage was applied in the range of 0 to 0.8 V in the state where the anode was positive and the cathode was negative, the capacitance increased. In contrast, when voltage was applied in the range of 0 to 2.5 V in the state where the anode was negative and the cathode was positive, the capacitance reduced. Then the hole density no was calculated by using the expressions (13) and (14).

In the hole-only elements showing space-charge-limited current as a direct current characteristic, the hole density was $10^{18}$ or less [/cm$^3$] in the device of z = 0.5 mass part and about $10^{18}$ [/cm$^3$] in the element of z = 1.0 mass part. In contrast, in the element showing ohmic current of z = 10 mass parts, the hole density was $2 \times 10^{19}$ [/cm$^3$].

Further, a hole density increases as a mass part of an ion polymerization initiator increases. This is because holes are doped chemically by the ion polymerization initiator.

It is concerned that an element exhibits metallic luster when a hole density increases up to $10^{22}$ [/cm$^3$].

Here, on the assumption that a hole density is proportional to a mass part of an ion polymerization initiator, when a hole density of an ion polymerization initiator of 10 mass parts is an order of $10^{19}$ [/cm$^3$], a desirable mass part of an ion polymerization initiator is 10,000 mass parts or less that is 1,000 times the 10 mass parts from the calculation of $10^{22}$ [/cm$^3$]/ $10^{19}$ [/cm$^3$] = 1,000.

In summary, an ion polymerization initiator is desirably 10 mass parts or more to 10,000 mass parts or less to a curable polymer (curable resin) of 100 mass parts.

**Example 2**

The manufacturing of an organic light emitting device and the measurement of a capacitance of an organic light emitting device are explained.

[Manufacturing of organic light emitting device]

A resin A(z) (z = 0.5 or 10 mass parts) is stacked as a hole transport layer (40 nm) over a glass substrate formed by patterning an ITO in a width of 1.6 mm by the method described in Example 1. Successively, the obtained glass substrate was transferred in a vacuum vapor deposition apparatus and CBP + Ir (piq) 3 (40 nm), BAlq (10 nm), Alq3 (30 nm), and LiF (film thickness 0.5 nm) were stacked in this order by vapor deposition. Finally, an Al layer 100 nm in film thickness and 1.6 mm in width was patterned. A plane where an ITO pattern and an Al pattern intersect comes to be a light emitting device and the area of the device is $1.6 \times 1.6$ mm$^2$.

After electrodes were formed, the substrate was transferred in a dry nitrogen environment without exposition to the atmosphere and sealed by bonding a sealing glass including an alkali-free glass of 0.7 mm having a counterbore of 0.4 mm and an ITO substrate by using a photocurable epoxy resin, and a macromolecular organic EL device of a multilayered structure was manufactured.

<Measurement example: capacitance of organic light emitting device>

Fig. 8 is a schematic configuration diagram showing an organic light emitting device and an impedance measurement system.

In the figure, an organic light emitting device 101 has a glass substrate 11, an anode 12, a hole transport layer 13, an emission layer 14, an electron transport layer 15, a cathode 16, and a sealing glass plate 17 and has a configuration formed by stacking them in this order. An LCR meter 502 is connected to the anode 12 and the cathode 16 of the organic light emitting device 101. An NF circuit block ZM2376 is used as the LCR meter 502.

In such a configuration, the capacitance of the organic light emitting device 101 was measured.

In an organic EL device A(z) (z = 10 mass parts) using a curable resin showing ohmic conductivity as a hole transport layer, the capacitance in the state of not applying voltage was $9 \times 10^{-9}$ [F]. The capacitance coincides with a geometric capacity C (capacitance determined by a geometric structure of a thickness and an area) defined by the following expression (17) when the dielectric constant $\varepsilon$ of each layer of the light emitting layer (CBP + Ir (piq) 3 (40 nm)) and the electron transport layer (BAlq (10 nm), Alq3 (30 nm), and LiF (film thickness 0.5 nm)) is set at 3.2 in the organic layers used in the present example, the total thickness W of the light emitting layer and the electron transport layer is set at 80.5 nm, and the area of the element is set at $1.6 \times 1.6$ mm$^2$.

[Num 17]

$$C = \frac{\varepsilon \cdot \varepsilon_0 \cdot S}{W} \qquad (17)$$

That is, a capacitance is given by the geometric capacitance of layers excluding the contribution of a hole transport layer in the organic layers. Further, even when voltage was applied from -0.5 V to 0.5 V between a cathode and an anode, the change of a capacitance was not seen. This indicates that the capacitance of a hole transport layer that is a curable resin showing ohmic conductivity can be ignored and the hole transport layer functions as a resistor.

On the other hand, in an organic EL device A(z) (z = 1 mass part) using a curable resin showing space-charge-limited current as a hole transport layer, the capacitance in the state of not applying voltage reduced to $7 \times 10^{-9}$ [F] . This is because a synthetic capacitance consisting of a geometric capacitance corresponding to the thicknesses of a emission layer and an electron transport layer observed in an organic EL device A(z) (z = 10 mass parts) and a capacitance of a curable resin showing space-charge-limited current reduced. Further, when voltage was applied from 0 V to 0.5 V between a cathode and an anode, a capacitance increased. Furthermore, when a voltage of 5 V or more is applied, a capacitance took a constant value of the geometric capacitance $9 \times 10^{-9}$ [F] corresponding to the thicknesses of an emission layer and an electron transport layer observed in an organic EL element A(z) (z = 10 mass parts). In contrast, when voltage was applied from 0 V to - 0.5 V between a cathode and an anode, a capacitance reduced. This is because a depletion layer appeared between a hole transport layer and a light emitting layer in a curable resin having a low hole density and showing space-charge-limited current.

<Application example: performance evaluation of organic light emitting device>

The performance of the organic EL devices A(z) (z = 0.5 and 10 mass parts) according to Example 2 was evaluated at room temperature (25°C) in the atmosphere.

Whereas the voltage for maintaining the brightness of 3,000 cd/$m^2$ was 5.8 V in the organic light emitting device A (z = 0.5 mass part), the voltage was 5.0 V in the light emitting device A (z = 10 mass parts). Further, change of brightness was measured under the condition of a constant voltage generating an initial brightness of 3,000 cd/$m^2$. As a result, whereas the time elapsed until the brightness was 1,500 cd/$m^2$ was 55 hours in the organic light emitting device A (z = 0.5 mass part), the time improved to 80 hours in the organic light emitting device A (z = 10 mass parts).

**Industrial Applicability**

An organic light emitting device according to the present invention can secure both a higher efficiency and a longer service life.

**List of Reference Signs**

101: organic EL device,
11: glass substrate,
12: anode,
13: hole transport layer (curable resin of ohmic conductivity),
14: light emitting layer,
15: electron transport layer,
16: cathode,
17: sealing glass plate,
21: glass substrate,
22: anode,
23a: hole transport layer (curable resin of space-charge-limited conductivity),
23b: hole transport layer (curable resin of space-charge-limited conductivity),
23c: hole transport layer (curable resin of ohmic conductivity),
23d: hole transport layer (curable resin of ohmic conductivity),
24: emission layer,
25: electron transport layer,
26: cathode,
27: hole carrier,
28: electron carrier

## Claims

1. An organic light emitting device comprising:

   an anode;
   a hole transport layer;
   a emission layer; and
   a cathode, wherein:

      the hole transport layer is arranged between the anode and the emission layer;
      the hole transport layer includes an ion polymerization initiator and a curable resin;
      the curable resin has a hole carrier generated by being doped chemically by the ion polymerization initiator; and
      the hole transport layer shows an ohmic conductivity.

2. The organic light emitting device according to claim 1,
   wherein a current density j (A/$m^2$) of the hole transport layer satisfies a following inequality (1),
   [Num 1]

$$\frac{j\varepsilon\varepsilon_0}{\mu(en_0)^2} < \frac{d}{20} \qquad (1)$$

   (in the inequality, $\varepsilon$ is a relative dielectric constant of the hole transport layer, $\varepsilon_0$ is a dielectric constant in a vacuum $8.85 \times 10^{-12}$ [F/m], $\mu$ is a mobility ($m^2$/V/sec) of holes in the hole transport layer, e is an elementary electric charge, no is a hole density (/$m^3$) of the hole transport layer, and d is a film thickness (m) of the hole transport layer).

3. The organic light emitting device according to claim 2,
   wherein a current density j (A/$m^2$) of the hole transport layer satisfies a following inequality (2),
   [Num 2]

$$\frac{j\varepsilon\varepsilon_0}{\mu(en_0)^2} < 1\text{Å} \qquad (2).$$

4. The organic light emitting device according to any one of claims 1 to 3,
   wherein a capacitance of the organic light emitting device is given by a geometric capacitance of organic layers excluding the hole transport layer.

5. The organic light emitting device according to claim 2,
   wherein the hole transport layer satisfies the inequality (1) in a region of 90% or more of an area of an interface in contact with the anode or the light emitting layer.

6. The organic light emitting device according to any one of claims 1 to 5,
   wherein a capacitance of the organic light emitting device is nearly constant under the condition of applying a voltage in the range of +0.5 V to -0.5 V between the anode and the cathode.

7. The organic light emitting device according to any one of claims 1 to 6,
   wherein the curable resin includes a substance formed by polymerizing a monomer having any one of following structural expressions (1) to (3),

[Ch 1]

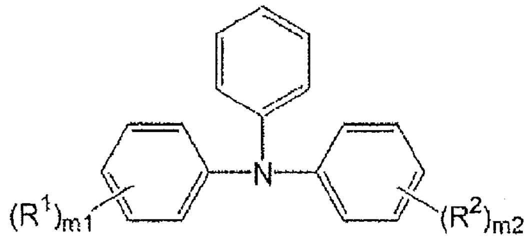

(1)

[Ch 2]

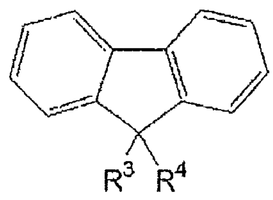

(2)

[Ch 3]

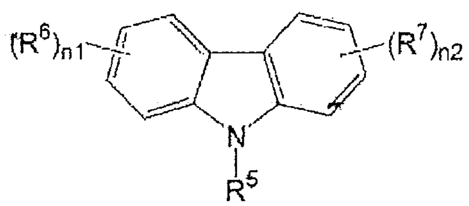

(3)

(in the expressions, $R^1$ to $R^7$ are functional groups, independently from each other, selected from the group of hydrogen, halogen, a cyano group, a nitro group, a linear, branched, or cyclic alkyl group of 1-22C, a linear, branched, or cyclic alkenyl group of 2-22C, a linear, branched, or cyclic alkynyl group of 2-22C, an aryl group of 6-21C, a heteroaryl group of 12-20C, an aralkyl group of 7-21C, and a heteroarylalkyl group of 13-20C (each of the functional groups is not replaced or replaced with one or more halogens), each of m1 and m2, independently from each other, is any integer between 0 and 5, and each of n1 and n2, independently from each other, is any integer between 0 and 4) .

**8.** The organic light emitting device according to any one of claims 1 to 7, wherein the ion polymerization initiator is a chemical compound having any one of following structural expressions (4) to (6),

[Ch 4]

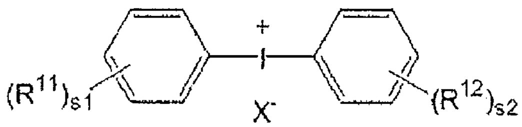

(4)

[Ch 5]

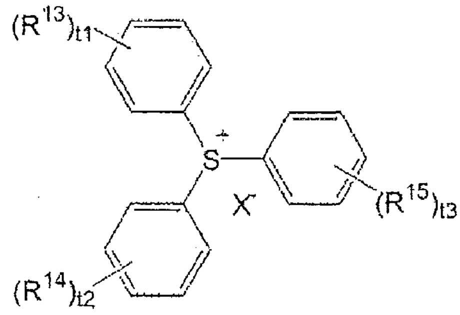

(5)

[Ch 6]

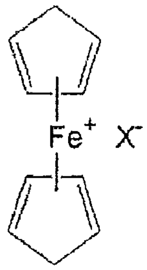

(6)

(in the expressions, $X^-$ is $Sb_6^-$, $(C_6F_5)_4B^-$, $CF_3SO_3^-$, $PF_6^-$, $BF_4^-$, $C_4F_9SO_3^-$, or $CH3C_6H_4SO_3^-$, $R^{11}$ to $R^{15}$ are functional groups, independently from each other, selected from the group of hydrogen, halogen, a cyano group, a nitro group, a linear, branched, or cyclic alkyl group of 1-22C, a linear, branched, or cyclic alkenyl group of 2-22C, a linear, branched, or cyclic alkynyl group of 2-22C, an aryl group of 6-21C, a heteroaryl group of 12-20C, an aralkyl group of 7-21C, and a heteroarylalkyl group of 13-20C, and each of s1, s2, t1, t2, and t3, independently from each other, is any integer between 0 and 5).

**9.** The organic light emitting device according to any one of claims 1 to 8, wherein a mass ratio of the ion polymerization initiator and the curable resin is 10:100 or more.

**10.** The organic light emitting device according to any one of claims 1 to 9, wherein a mass ratio of the ion polymerization initiator and the curable resin is 10:100 or more to 10,000:100 or less.

FIG. 1

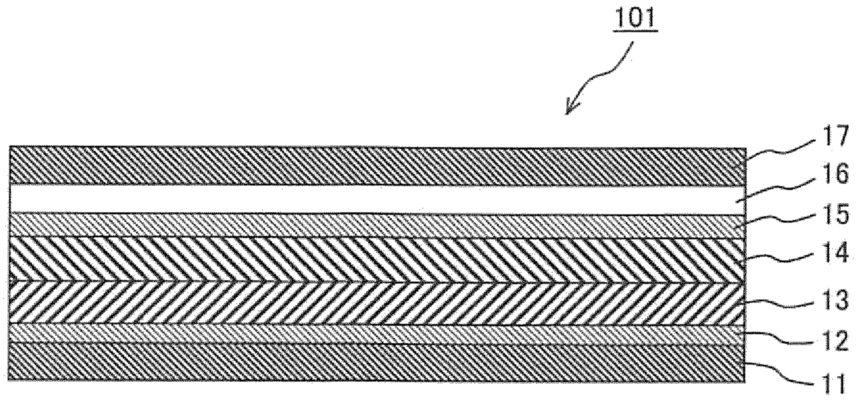
101
17
16
15
14
13
12
11

FIG. 2

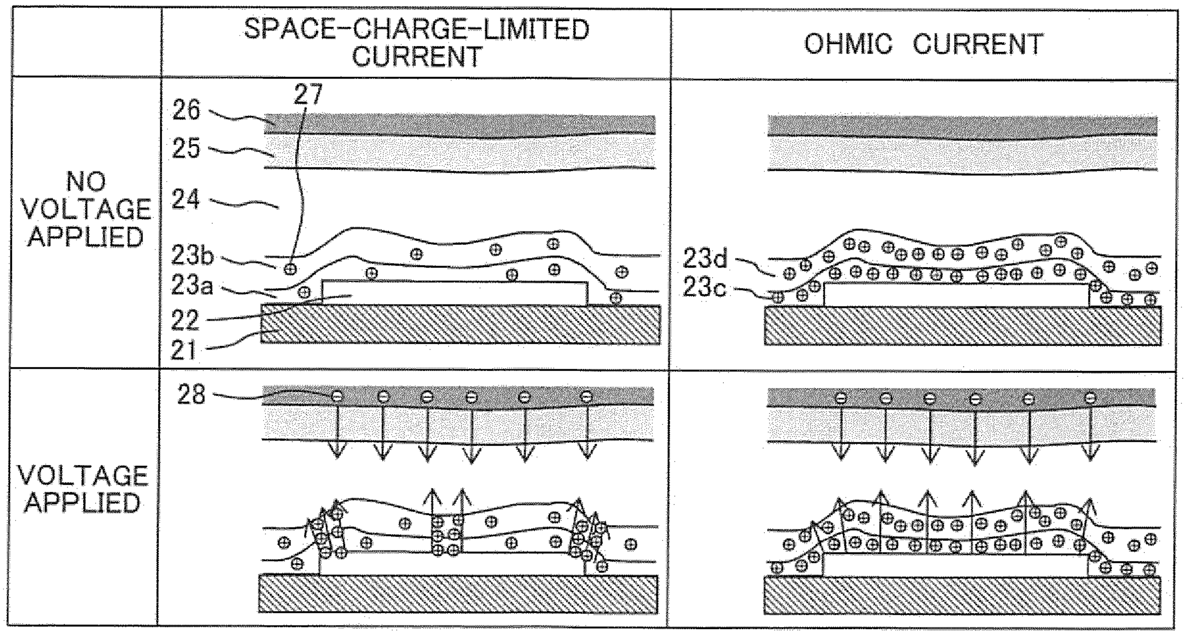
SPACE-CHARGE-LIMITED CURRENT
OHMIC CURRENT
NO VOLTAGE APPLIED
VOLTAGE APPLIED
26
25
24
27
23b
23a
22
21
23d
23c
28

FIG. 3

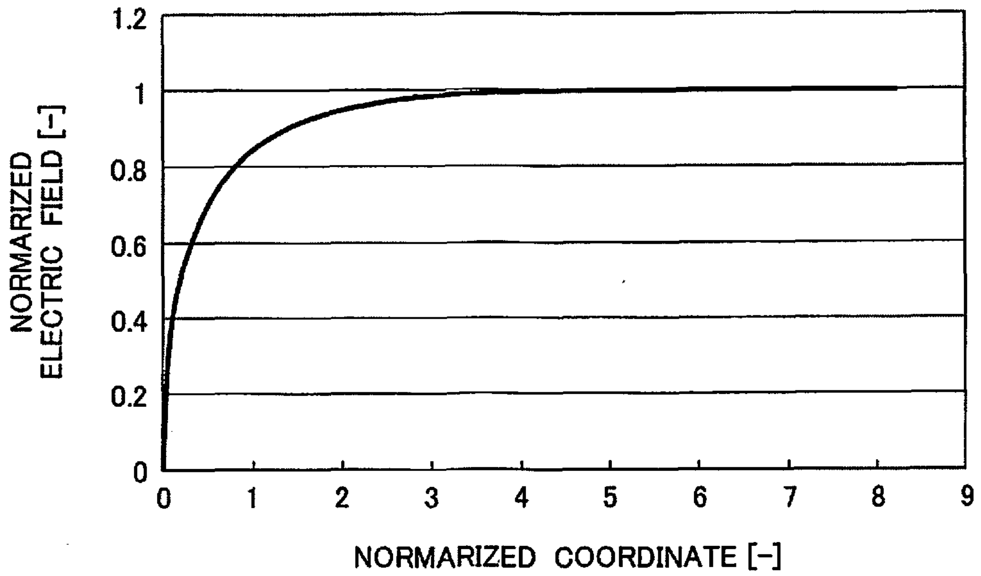
1.2
1
0.8
0.6
0.4
0.2
0
NORMARIZED
ELECTRIC FIELD [-]
0
1
2
3
4
5
6
7
8
9
NORMARIZED COORDINATE [-]

FIG. 4

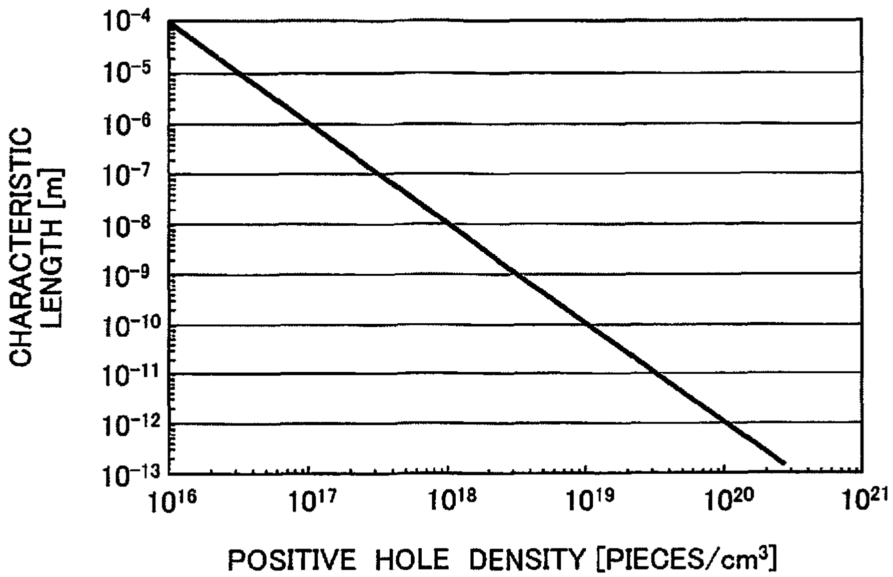
10-4
10-5
10-6
10-7
10-8
10-9
10-10
10-11
10-12
10-13
CHARACTERISTIC
LENGTH [m]
1016
1017
1018
1019
1020
1021
POSITIVE HOLE DENSITY [PIECES/cm3]

FIG. 5A

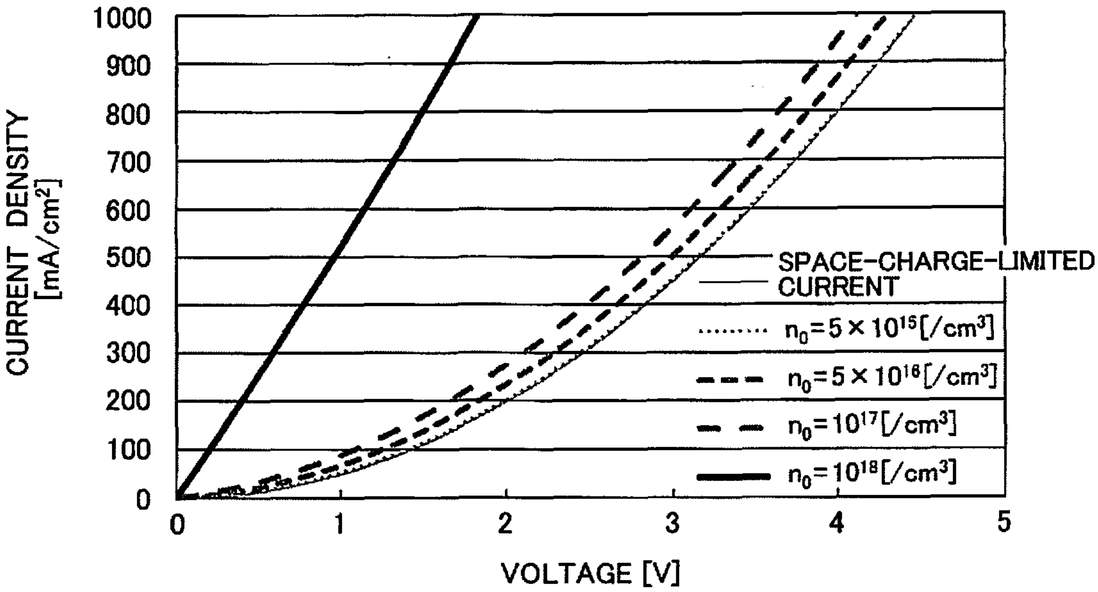
1000
900
800
700
600
500
400
300
200
100
0
CURRENT DENSITY [mA/cm²]
0
1
2
3
4
5
VOLTAGE [V]
SPACE-CHARGE-LIMITED CURRENT
$n_0=5\times10^{15}$[/cm³]
$n_0=5\times10^{16}$[/cm³]
$n_0=10^{17}$[/cm³]
$n_0=10^{18}$[/cm³]

FIG. 5B

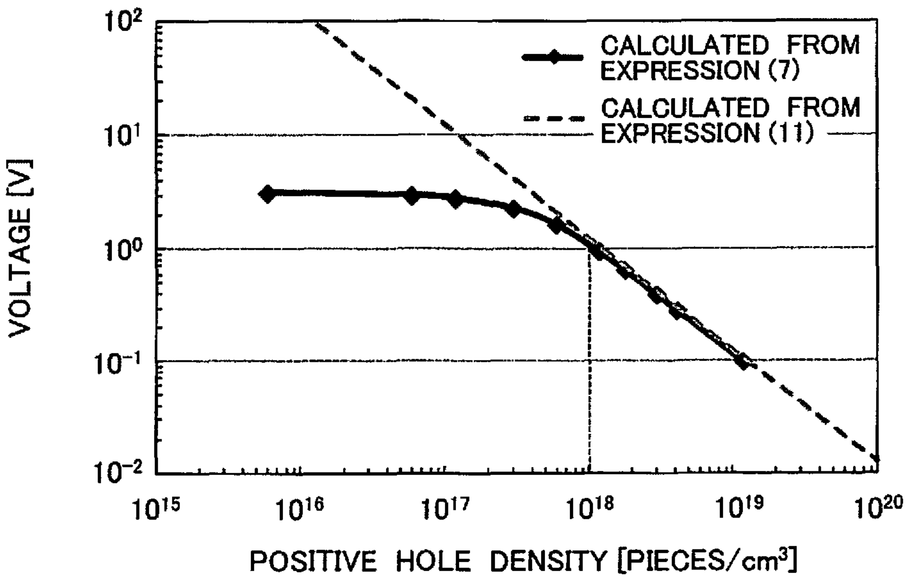
$10^2$
$10^1$
$10^0$
$10^{-1}$
$10^{-2}$
VOLTAGE [V]
$10^{15}$
$10^{16}$
$10^{17}$
$10^{18}$
$10^{19}$
$10^{20}$
POSITIVE HOLE DENSITY [PIECES/cm³]
CALCULATED FROM EXPRESSION (7)
CALCULATED FROM EXPRESSION (11)

FIG. 6A

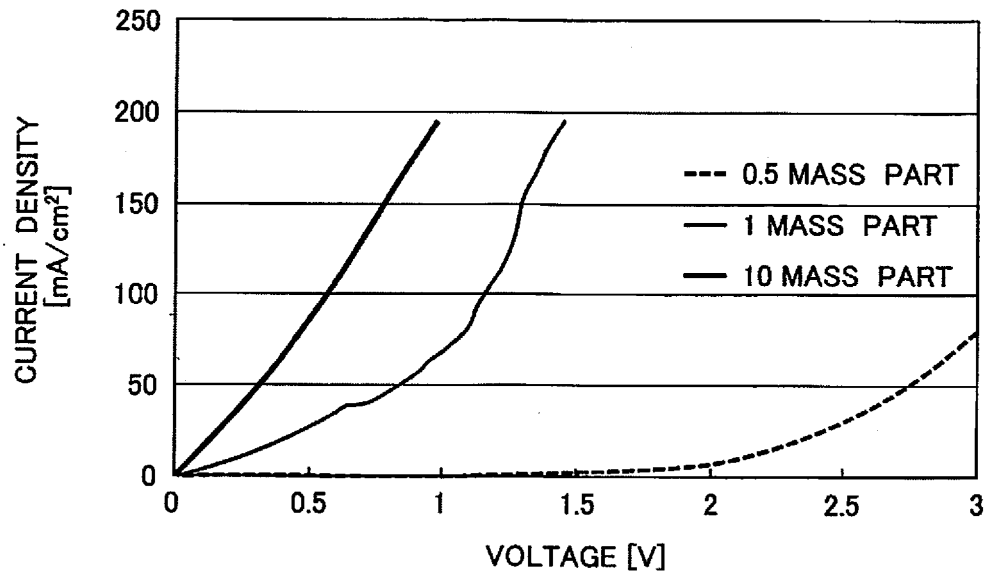
250
200
150
100
50
0
CURRENT DENSITY [mA/cm²]
0
0.5
1
1.5
2
2.5
3
VOLTAGE [V]
0.5 MASS PART
1 MASS PART
10 MASS PART

FIG. 6B

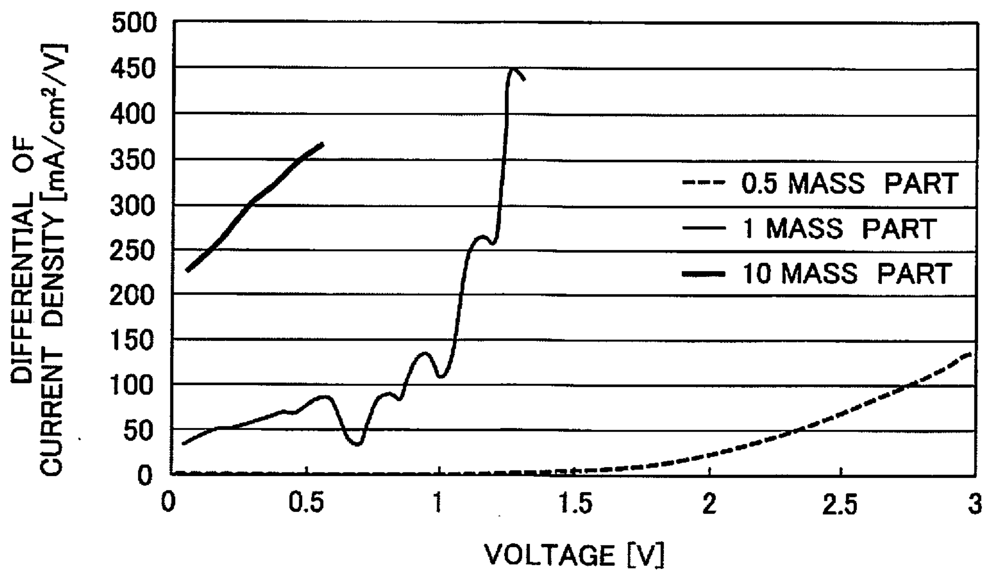
500
450
400
350
300
250
200
150
100
50
0
DIFFERENTIAL OF CURRENT DENSITY [mA/cm²/V]
0
0.5
1
1.5
2
2.5
3
VOLTAGE [V]
0.5 MASS PART
1 MASS PART
10 MASS PART

FIG. 7

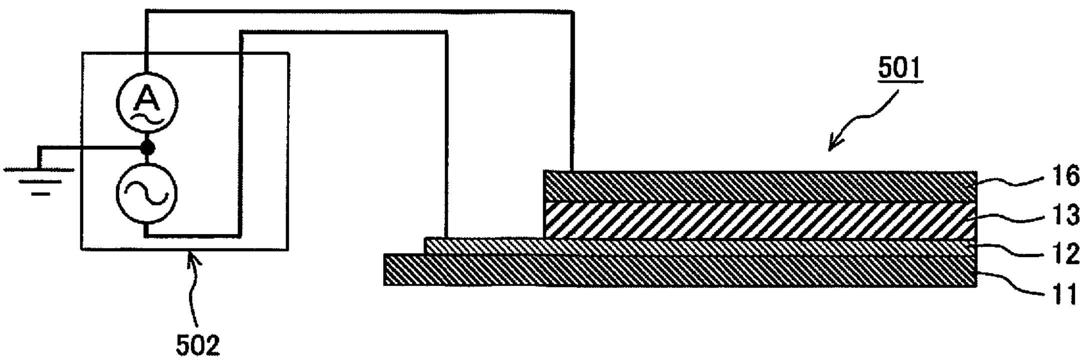


FIG. 8

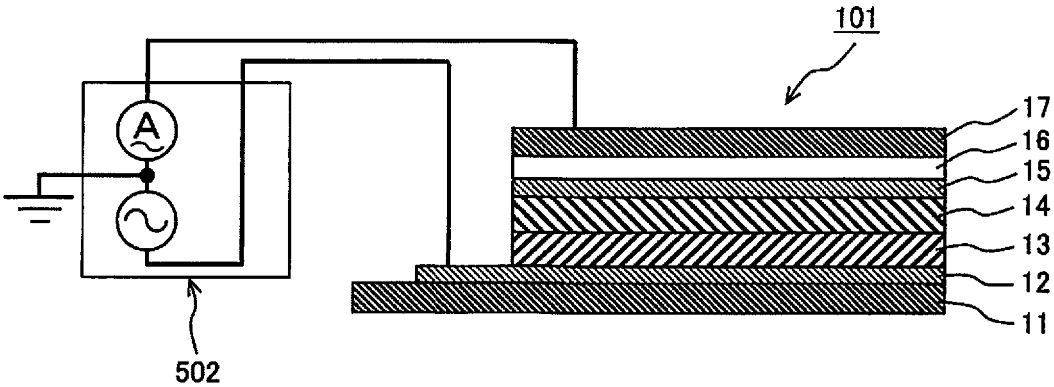

## INTERNATIONAL SEARCH REPORT

International application No. PCT/JP2016/084757

**A. CLASSIFICATION OF SUBJECT MATTER**

*H01L51/50*(2006.01)i, *C08G61/12*(2006.01)i

According to International Patent Classification (IPC) or to both national classification and IPC

**B. FIELDS SEARCHED**

Minimum documentation searched (classification system followed by classification symbols)
H01L51/50, C08G61/12

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2017 |
| Kokai Jitsuyo Shinan Koho | 1971-2017 | Toroku Jitsuyo Shinan Koho | 1994-2017 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 2015-12105 A (Hitachi Chemical Co., Ltd.), 19 January 2015 (19.01.2015), claims; paragraphs [0016], [0050] to [0070] (Family: none) | 1-10 |
| A | JP 2006-233162 A (Mitsubishi Chemical Corp.), 07 September 2006 (07.09.2006), entire text & US 2007/0207341 A1 & WO 2005/089024 A1 & EP 1725079 A1 & KR 10-2006-0122981 A & CN 1930921 A | 1-10 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 02 February 2017 (02.02.17) | 14 February 2017 (14.02.17) |

| Name and mailing address of the ISA/ | Authorized officer |
|---|---|
| Japan Patent Office<br>3-4-3,Kasumigaseki,Chiyoda-ku,<br>Tokyo 100-8915,Japan | Telephone No. |

Form PCT/ISA/210 (second sheet) (January 2015)

**INTERNATIONAL SEARCH REPORT**

International application No.
PCT/JP2016/084757

C (Continuation). DOCUMENTS CONSIDERED TO BE RELEVANT

| Category* | Citation of document, with indication, where appropriate, of the relevant passages | Relevant to claim No. |
|---|---|---|
| A | JP 2003-264085 A (Semiconductor Energy Laboratory Co., Ltd.), 19 September 2003 (19.09.2003), entire text & US 2003/0127967 A1 & EP 1318553 A2 & TW 200301021 A & KR 10-2003-0046327 A & CN 1433096 A & SG 113443 A | 1-10 |

Form PCT/ISA/210 (continuation of second sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2008227483 A
- WO 2014038071 A